Europäisches Patentamt

(19) European Patent Office

Office européen des brevets

(11) **EP 1 332 826 A1**

(12) **EUROPÄISCHE PATENTANMELDUNG**

(43) Veröffentlichungstag:
06.08.2003 Patentblatt 2003/32

(51) Int Cl.$^7$: **B23K 20/00**

(21) Anmeldenummer: 02002445.1

(22) Anmeldetag: 01.02.2002

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **Esec Trading S.A.**
**6330 Cham (CH)**

(72) Erfinder:
• **Mayer, Michael, Dr.**
**6345 Neuheim (CH)**
• **Schwizer, Jürg**
**6264 Pfaffnau (CH)**

(74) Vertreter: **Falk, Urs, Dr.**
**Patentanwaltsbüro Dr. Urs Falk,**
**Eichholzweg 9A**
**6312 Steinhausen (CH)**

(54) **Verfahren für die Bestimmung optimaler Bondparameter beim Bonden mit einem Wire Bonder**

(57) Optimale Bondparameter für eine Bondkraft $F_B$ und eine Ultraschallgrösse P und, fakultativ, mindestens einen weiteren Bondparameter eines Wire Bonders lassen sich ermitteln mittels eines Verfahrens mit den folgenden Schritten:

a) Durchführen von mehreren Bondvorgängen, wobei die Bondkraft $F_B$ und die Ultraschallgrösse P und, gegebenenfalls, der mindestens eine weitere Bondparameter in je einem vorbestimmten Bereich in diskreten Schritten variiert werden, wobei während des Bondens für jeden Bondvorgang mittels eines Sensors erzeugte elektrische Signale erfasst werden,

b) für jeden Bondvorgang Ermitteln einer Grösse G aus den während des Bondvorganges vom Sensor gelieferten elektrischen Signalen,

c) Bestimmung des maximalen Wertes der Grösse G und der zugehörigen Werte für die Bondkraft $F_B$, die Ultraschallgrösse P und, gegebenenfalls, den mindestens einen weiteren Bondparameter oder Bestimmung eines globalen Maximums der Grösse G und Bestimmung der zugehörigen Werte für die Bondkraft $F_B$, die Ultraschallgrösse P und, gegebenenfalls, den mindestens einen weiteren Bondparameter oder Bestimmung eines Bereichs der Grösse G, in welchem die Grösse G vorbestimmte Kriterien erfüllt, und Bestimmung der zugehörigen Werte für die Bondkraft $F_B$, die Ultraschallgrösse P und, gegebenenfalls, den mindestens einen weiteren Bondparameter.

Fig. 6

Printed by Jouve, 75001 PARIS (FR)

**Beschreibung**

Die Erfindung betrifft ein Verfahren für die Bestimmung optimaler Bondparameter beim Bonden mit einem Wire Bonder.

Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonding. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonding. Nach dem Befestigen des Drahtes auf dem Anschlusspunkt des Substrats wird der Draht abgerissen und der nächste Bondzyklus kann beginnen.

Das Ball-bonding wird von verschiedenen Faktoren beeinflusst. Um Bondverbindungen von vorbestimmter Qualität zu erzielen, müssen für einen bestimmten Prozess die passenden Werte mehrerer physikalischer und/oder technischer Parameter eruiert werden. Beispiele solcher Parameter sind:

- die Bondkraft, das ist die Normalkraft, die die Kapillare während des Bondvorganges auf die Bondkugel bzw. den Anschlusspunkt des Halbleiterchips ausübt,
- ein hierin als Ultraschallgrösse P bezeichneter Parameter, der die Beaufschlagung des Ultraschallgebers mit Ultraschall steuert. Die Ultraschallgrösse ist z.B. die Amplitude des Wechselstroms, der durch den Ultraschallgeber des Horns fliesst, oder die Amplitude der Wechselspannung, die an den Ultraschallgeber angelegt wird, oder die Leistung oder eine andere Grösse,
- eine hierin als Ultraschallzeit T bezeichnete Zeitdauer, die angibt, wie lange der Ultraschallgeber mit der Ultraschallgrösse P beaufschlagt wird,
- die Auftreffgeschwindigkeit der Kapillare auf den Anschlusspunkt,
- ein binärer Parameter, der angibt, ob der Ultraschallgeber bereits vor dem Auftreffen der Kapillare auf dem Anschlusspunkt mit der Ultraschallgrösse beaufschlagt wird.

Der Erfindung liegt die Aufgabe zugrunde, ein Verfahren für die einfache Bestimmung optimaler Bondparameter zu entwickeln.

Die Erfindung besteht aus den im Anspruch 1 angegebenen Merkmalen. Vorteilhafte Ausgestaltungen ergeben sich aus den abhängigen Ansprüchen.

Optimale Bondparameter für eine Bondkraft $F_B$ und eine Ultraschallgrösse P und, fakultativ, mindestens einen weiteren Bondparameter eines Wire Bonders lassen sich erfindungsgemäss ermitteln mittels eines Verfahrens mit den folgenden Schritten:

a) Durchführen von mehreren Bondvorgängen, wobei die Bondkraft $F_B$ und die Ultraschallgrösse P und, gegebenenfalls, der mindestens eine weitere Bondparameter in je einem vorbestimmten Bereich in diskreten Schritten variiert werden, wobei während des Bondens für jeden Bondvorgang mittels eines Sensors erzeugte elektrische Signale erfasst werden,

b) für jeden Bondvorgang Ermitteln einer Grösse G aus den während des Bondvorganges vom Sensor gelieferten elektrischen Signalen,

c) Bestimmung des maximalen Wertes der Grösse G und der zugehörigen Werte für die Bondkraft $F_B$, die Ultraschallgrösse P und, gegebenenfalls, den mindestens einen weiteren Bondparameter oder Bestimmung eines globalen Maximums der Grösse G und Bestimmung der zugehörigen Werte für die Bondkraft $F_B$, die Ultraschallgrösse P und, gegebenenfalls, den mindestens einen weiteren Bondparameter oder Bestimmung eines Bereichs der Grösse G, in welchem die Grösse G vorbestimmte Kriterien erfüllt, und Bestimmung der zugehörigen Werte für die Bondkraft $F_B$, die Ultraschallgrösse P und, gegebenenfalls, den mindestens einen weiteren Bondparameter.

Beispiele für die Grösse G sind physikalische Grössen wie die während des Bondvorganges geleistete Reibearbeit, oder die während des Bondvorganges auf den Halbleiterchip übertragene Wärmeenergie, oder die während des Bondvorganges in die Bildung der intermetallischen Verbindung zwischen dem Golddraht und dem Kontaktbereich gesteckte Energie oder die relative Änderung des Reibungskoeffizienten, etc.

Nachfolgend werden Ausführungsbeispiele der Erfindung anhand der Zeichnung näher erläutert.

Es zeigen:

Fig. 1, 2     einen piezoresistiven Sensor,
Fig. 3        ein elektrisches Schaltbild des Sensors,
Fig. 4        Teile eines Wire Bonders,
Fig. 5        Wellenformen des Signals des piezoresistiven Sensors während eines Bondprozesses,
Fig. 6        aus dem Signal des piezoresistiven Sensors abgeleitete Signale,
Fig. 7        das von einem Temperatursensor während eines Bondprozesses gelieferte Signal, und
Fig. 8        eine Messunganordnung mit einem Vibrometer als Sensor.

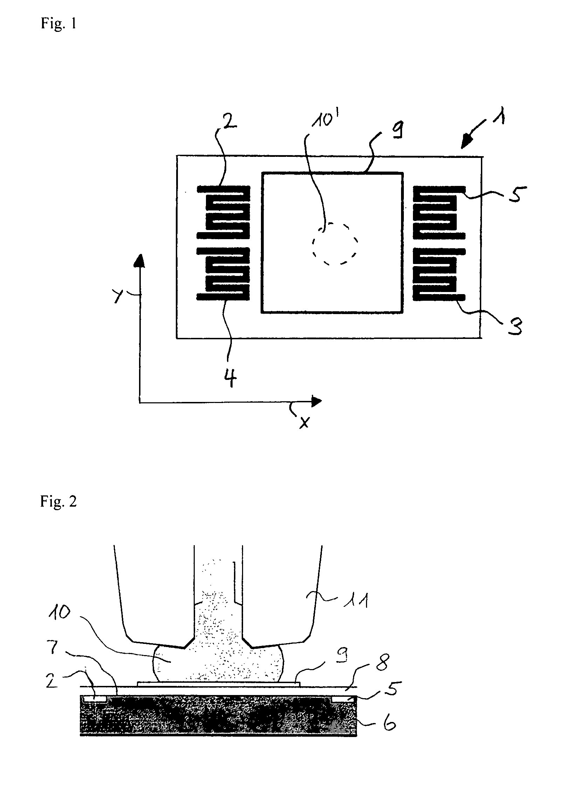

Die Fig. 1 und 2 zeigen in der Aufsicht bzw. im Querschnitt einen in einem Halbleiterchip integrierten Sensor 1, der aus vier piezoresistiven Elementen 2 bis 5 besteht, die elektrisch zu einer Wheatstone Brücke geschaltet sind. Das Ausgangssignal des Sensors 1 entspricht dem Ausgangssignal der Wheatstone Brücke. Der Sensor 1 besteht vorzugsweise aus n-dotiertem Silizium 6, in dessen einer Oberfläche 7 die piezoresistiven Elemente 2 bis 5 als mäanderförmige Widerstandsbahnen aus p-dotiertem Silizium eingebettet sind. Die Oberfläche 7 des Sensors 1 ist mit einer Isolationsschicht 8 bedeckt. Die piezoresistiven Elemente 2 bis 5 sind ausserhalb eines etwa quadratischen metallischen Kontaktbereiches 9 angeordnet, innerhalb dem die Spitze der Kapillare 11 eines Wire Bonders den zu einer Kugel geschmolzenen Draht auf den Halbleiterchip drückt. Der Bereich, wo die Bondkugel 10 im Idealfall auf den Sensor 1 drückt, ist mit einem gestrichelten kreisförmigen Ring 10' dargestellt. In der Fig. 1 sind die Achsen eines kartesischen Koordinatensystems mit x und y bezeichnet. Die x-Richtung verläuft vorzugsweise parallel zu einer [110] Achse des Siliziumkristalls. Die mäanderförmigen Bahnen der piezoresistiven Elemente 2 bis 5 verlaufen in x-Richtung und sind, in x-Richtung gesehen, links und rechts ausserhalb des Kontaktbereiches 9 angeordnet. Sie dienen zur Erfassung der von der Bondkugel bei Beaufschlagung mit Ultraschall im Sensor 1 in x-Richtung induzierten Scherkraft $F_x$. Bei der Messung ist der Sensor 1 bezüglich des Wire Bonders so zu orientieren, dass die Schwingungsrichtung der Kapillare 11 möglichst parallel zur x-Richtung verläuft.

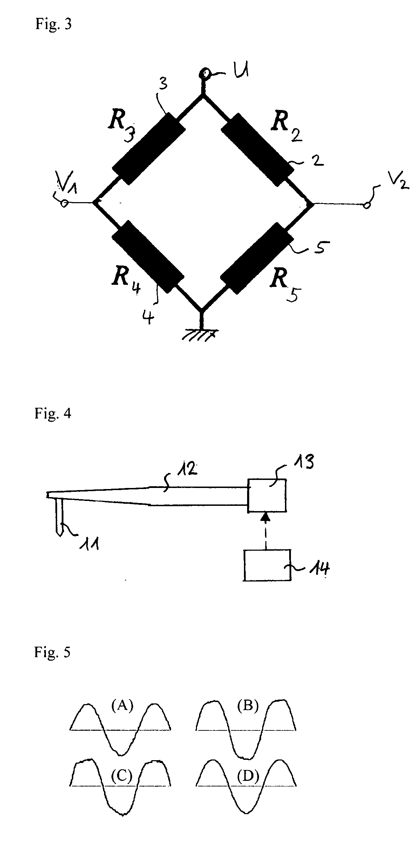

Die Fig. 3 zeigt das elektrische Schaltbild der aus den vier piezoresistiven Elementen 2 bis 5 gebildeten Wheatstone Brücke. Die vier piezoresistiven Elemente 2 bis 5 sind über gewöhnliche Leiterbahnen aus Aluminium verdrahtet. Die Wheatstone Brücke wird vorzugsweise aus einer Konstantspannungsquelle mit einer Spannung U gespeist. Die Ausgangsspannung $U_{Out} = V_1 - V_2$ der Wheatstone Brücke ergibt sich dann zu

$$U_{Out} = \frac{R_2R_4 - R_3R_5}{(R_3 + R_4)^*(R_2 + R_5)}\, U \qquad\qquad (1),$$

wobei $R_2$ bis $R_5$ die ohmschen Widerstände der piezoresistiven Elemente 2 bis 5 bezeichnen.

Die Fig. 4 zeigt schematisch Teile eines Wire Bonders, nämlich ein Horn 12, an dessen Spitze die Kapillare 11 eingespannt ist, einen aus Piezoelementen gebildeten Ultraschallgeber 13 und eine den Ultraschallgeber 13 speisende Energiequelle 14.

Im folgenden wird nun das erfindungsgemässe Verfahren für die Bestimmung optimaler Bondparameter für die Bondkraft $F_B$, eine Ultraschallgrösse P und, fakultativ, mindestens eines weiteren Bondparameters im Detail erläutert. Der erste Schritt des Verfahrens besteht darin, dass eine vorbestimmte Anzahl von Bondvorgängen durchgeführt wird, wobei die Bondkraft $F_B$ und die Ultraschallgrösse P und gegebenenfalls weitere Bondparameter in einem vorbestimmten Bereich in diskreten Schritten variiert werden. Jeder Bondvorgang wird mittels mindestens einem Sensor überwacht. Das vom Sensor gelieferte Signal wird gespeichert und ausgewertet. Dabei wird aus dem Sensorsignal eine den Bondvorgang charakterisierende Grösse G ermittelt. Die folgenden Beispiele zeigen, wie die während des Bondvorganges geleistete Reibearbeit, die während des Bondvorganges auf den Halbleiterchip übertragene Wärmeenergie, und die relative Änderung des Reibungskoeffizienten ermittelt werden können.

Der Einfachheit halber werden im folgenden Beispiel nur die Bondkraft $F_B$ in n = 1..h und die Ultraschallgrösse P in m = 1..k Schritten variiert. Jedem der n*m Bondvorgänge ist somit eine Bondkraft $F_n$ und eine Ultraschallgrösse $P_m$, sowie eine zu erfassende Grösse $G_{n,m}$ zugeordnet. Ein Beispiel für die Ultraschallgrösse P ist die Amplitude des durch den Ultraschallgeber fliessenden Wechselstroms, d.h. dann entspricht jeder Wert $P_m$ einer Amplitude $I_m$. Bei jedem Bondvorgang wird die Kapillare 11 auf einen neuen Kontaktbereich 9 abgesetzt und eine Bondkugel gebondet. Dies erfolgt wie üblich so:

1. Die Kapillare 11 wird auf einen neuen Kontaktbereich 9 aufgesetzt.
2. Die Kapillare 11 wird mit der vorgegebenen Bondkraft $F_n$ beaufschlagt.
3. Sobald die Bondkraft $F_n$ aufgebaut ist, wird der Ultraschallgeber mit einem konstanten Wechselstrom $P_m = I(t) = I_m * \cos(2*\pi*f*t)$ mit der vorgegebenen Amplitude $I_m$ und der Frequenz f beaufschlagt. Das von einem dem Kontaktbereich 9 zugeordneten Sensor während des Bondvorganges gelieferte Signal wird erfasst und ausgewertet, d.h. es wird für jeden Bondvorgang aus dem vom Sensor gelieferten Signal die charakteristische Grösse

$G_{n,m}$ ermittelt.

Im folgenden werden nun verschiedene Beispiele für die charakteristische Grösse $G_{n,m}$ und deren Berechnung aus dem vom Sensor gelieferten Signal näher beschrieben.

Beispiel 1

Bei diesem Beispiel ist die Grösse $G_{n,m}$ die während des Bondvorganges geleistete Reibearbeit $W_{n,m}$ oder eine dazu proportionale Grösse. Für die Ermittlung von $G_{n,m}$ wird ein Halbleiterchip benutzt, der eine Vielzahl von Kontaktbereichen 9 mit je einem zugeordneten Sensor gemäss Fig. 1 enthält. Für jeden der n*m Bondvorgänge wird ein anderer Kontaktbereich 9 benutzt. Während eines einzelnen Bondvorgangs wird das von dem dem benutzten Kontaktbereich 9 zugeordneten Sensor gelieferte Signal $U_{out}(t)$ erfasst und ausgewertet.

Die Fig. 5 zeigt die Wellenform des Signals $U_{Out}(t)$ zu verschiedenen Zeitpunkten während des Bondprozesses. Die horizontale Achse bezeichnet die Zeitachse t. Zu Beginn und am Ende des Bondprozesses ist die Wellenform nahezu sinusförmig (Kurven A und D). In einer Zwischenphase hingegen tritt eine Abflachung der Wellenform auf (Kurven B und C). Dies ist gleichbedeutend mit dem Auftreten von harmonischen Oberwellen. Ein physikalisches Modell für dieses Verhalten kann dem Artikel "Active test chips for in situ wire bonding process characterisation" entnommen werden, der im Konferenzbericht der Semicon Singapur 2001 anlässlich des "Advanced Packaging Technologies Seminar I" vorgestellt und publiziert wurde. Eine weitere Referenz zu diesem physikalischen Modell ist folgende: J.Schwizer, M.Mayer, D.Bolliger, O.Paul, and H. Baltes, "Thermosonic Ball Bonding: Friction Model Based on Integrated Microsensor Measurements", Konferenzbericht des 24th IEEE/CPMT Intl. Electronic Manufacturing Technology Symposium IEMT'99 in Austin, Texas, Oct. 18-19, 1999, pp. 108-114.

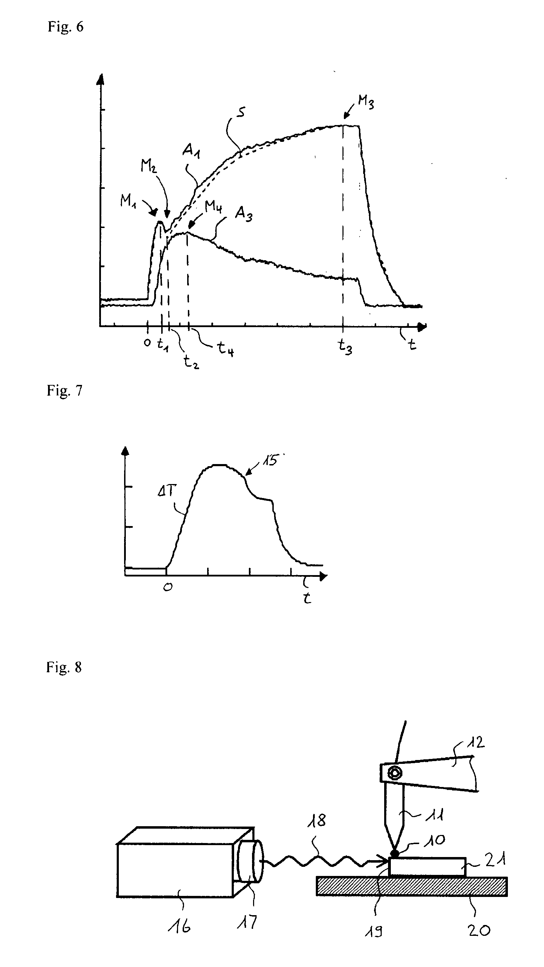

Das vom jeweiligen Sensor gelieferte Signal $U_{Out}(t)$ oszilliert mit der Frequenz f des durch den Ultraschallgeber 13 fliessenden Wechselstromes. Die Fig. 6 zeigt schematisch die Umhüllende $S(t)$ des Signals $U_{Out}(t)$ (gestrichelte Linie), die Umhüllende der ersten Harmonischen $A_1(t)$ und die Umhüllende der dritten Harmonischen $A_3(t)$ des Signals $U_{Out}(t)$. Das Signal $A_3(t)$ ist fünffach vergrössert dargestellt. Wenn der Ultraschall am Zeitpunkt $t_0 = 0$ eingeschaltet wird, dann steigt das Signal $S(t)$ an, durchläuft zum Zeitpunkt $t_1$ ein lokales Maximum $M_1$, zum Zeitpunkt $t_2$ ein lokales Minimum $M_2$ und steigt dann weiter an bis zu einem Zeitpunkt $t_3$ ein globales Maximum $M_3$ erreicht wird. Das lokale Maximum $M_1$ deutet daraufhin, dass nun die Reibung zwischen dem Bonddraht und dem Kontaktbereich einsetzt. Aus diesem Grund tritt nun die dritte Harmonische auf, deren Umhüllende $A_3(t)$ zunächst zunimmt, zum Zeitpunkt $t_4$ ein Maximum $M_4$ erreicht, dann wieder abnimmt und schliesslich auf einem etwa konstanten Niveau verharrt. Das Erreichen des konstanten Niveaus deutet darauf hin, dass der Bondvorgang beendet werden kann. Aus dem zeitlichen Verlauf der Signale $S(t)$, $A_1(t)$ und $A_3(t)$ wird die während des Bondvorganges geleistete Reibearbeit $W_{n,m}$ ermittelt zu:

$$W_{n,m} = \int_{t_a}^{t_b} Q(t)dt, \tag{1}$$

wobei hier der Zeitpunkt $t_a$ den Beginn der Reibung, der Zeitpunkt $t_b$ das Ende der Reibung und $Q(t)$ die Reibeleistung bezeichnen.

Unter Zugrundelegung des in den oben erwähnten Artikeln erläuterten Stick-Slip-Modells lässt sich eine Beziehung zwischen der Reibeleistung $Q(t)$ und den Signalen $S(t)$, $A_1(t)$ und $A_3(t)$ herleiten. Die Reibeleistung $Q(t)$ kann angenähert dargestellt werden durch

$$Q(t) = k * [S^2(t) * (h^{-1}(t)-1)] \tag{2}$$

wobei die Grösse $h(t)$ eine von dem Verhältnis $a_3(t) = A_3(t)/A_1(t)$ abhängige Grösse und k eine Konstante bezeichnen. Für $h(t)$ wurde die Beziehung

$$h(t) = b_1 * a_3^3(t) + b_2 * a_3^2(t) + b_3 * a_3(t) + b_0 \tag{3}$$

mit den Konstanten $b_1 = 1.4587$, $b_2 = -2.1090$, $b_3 = -2.4655$ und $b_0 = 1.0006$ gefunden.

Für die Berechnung der Reibearbeit $W_{n,m}$ gemäss Gleichung (1) müssen nun noch die Zeitpunkte $t_a$ und $t_b$ bestimmt werden. Wie bereits erwähnt, scheint es aus physikalischer Sicht so zu sein, dass das Verbindungswachstum einsetzt, wenn das Signal des Sensors zum Zeitpunkt $t_2$ das lokale Minimum $M_2$ erreicht. Für den Zeitpunkt $t_a$ kann deshalb der Zeitpunkt $t_2$ gewählt werden. Aus einem analogen Grund kann für den Zeitpunkt $t_b$ der Zeitpunkt verwendet werden, ab dem das Signal $A_3(t)$ annähernd konstant ist. Beim Beispiel in der Fig. 6 fällt dieser Zeitpunkt mit dem Zeitpunkt $t_3$ zusammen. Oder es kann für den Zeitpunkt $t_b$ der Zeitpunkt verwendet werden, ab dem das Signal $A_3(t)$ kleiner als ein vorbestimmter Betrag des Maximalwertes $A_{3max}$ von $A_3(t)$ ist, z.B. ab dem $A_3(t) < 0.5 * A_{3max}$ oder ab dem $A_3(t) < 0.25 * A_{3max}$ ist.

Es kommt vor, dass das lokale Maximum $M_1$ und das lokale Minimum $M_2$ nicht auftreten, sondern dass sich nur die Steigung des Signals $S(t)$ ändert. Diese Änderungen sind aber ausgeprägt genug, so dass in diesem Fall anstelle des Zeitpunktes $t_1$, an dem sonst das lokale Maximum $M_1$ auftritt, ein äquivalenter Zeitpunkt $t_{10}$ bestimmt werden kann, an dem der Anstieg des Signals $S(t)$ ziemlich abrupt flacher wird, sowie anstelle des Zeitpunktes $t_2$, an dem sonst das lokale Minimum $M_2$ auftritt, ein äquivalenter Zeitpunkt $t_{20}$, an dem der Anstieg des Signals $S(t)$ wieder ziemlich abrupt steiler wird. Für den Zeitpunkt $t_a$ kann dann der Zeitpunkt $t_{10}$ gewählt werden.

Aus den Gleichungen (1), (2) und (3) lässt sich somit für jeden durch die Indices n und m charakterisierten Bondvorgang eine Grösse $G_{n,m}$ bestimmen, die mit der Reibearbeit $W_{n,m}$ durch die in Gleichung (2) auftretende, noch unbekannte Konstante k verknüpft ist:

$$G_{n,m} = W_{n,m} / k \qquad (4)$$

Aus den n*m Reibearbeiten $W_{n,m}$ lassen sich nun die ganzzahligen Indices $n_1$ und $m_1$ desjenigen Bondvorganges bestimmen, bei dem die Grösse $G_{n1,m1}$ maximal ist. Die Indices $n_1$ und $m_1$ geben also an, mit welchen Bondparametern die grösste Reibearbeit erreicht wird. Alternativ kann die Auswertung auch mit üblichen mathematischen Methoden erfolgen, um das globale Maximum einer durch die Grösse $G_{n,m}$ aufgespannten polynomen Funktion zu bestimmen, wobei dann die Indices $n_1$ und $m_1$ auch nichtganzzahlige Zahlen sein können. In diesem Fall sind anschliessend die zugehörigen optimalen Werte für die Bondkraft $F_B$ und für den Parameter P des Ultraschallgebers durch Interpolation zu bestimmen.

Es ist nun vorteilhaft, aus den Werten $G_{n,m}$ die entsprechenden Werte für die Scherkraft oder gegebenenfalls die Scherfestigkeit zu ermitteln, die definiert ist als Scherkraft pro Kontaktfläche. Scherkraft und Scherfestigkeit sind allgemein akzeptierte Qualitätsparameter für Ballbond-Verbindungen. Unter der Annahme, dass die Scherkraft $F_S$, die nötig ist, um die auf den jeweiligen Kontaktbereich 9 gebondete Bondkugel abzuscheren, proportional zu der während des Bondvorganges geleisteten Reibearbeit ist, d.h. unter der Annahme dass $F_S = \alpha*W$ gilt, wobei die Grösse $\alpha$ eine Konstante ist und die Grösse W die zur Scherkraft $F_S$ zugehörige Reibearbeit bezeichnet, erhält man mit diesem Verfahren also diejenigen Bondparameter, mit denen sich die grösste Scherkraft erreichen lässt.

Wenn die optimalen Bondparameter ermittelt worden sind, dann kann mittels eines Schertestes überprüft werden, ob die mit den optimalen Bondparametern gebondeten Bondkugeln die für den entsprechenden Bondprozess geforderte Scherkraft tatsächlich erreichen. Weiter kann die Konstante $\alpha$ mittels eines Schertests bestimmt werden. Wenn die Konstante $\alpha$ einmal bekannt ist, dann kann bei späteren Optimierungsprozessen nicht nur bestimmt werden, welche Bondparameter die maximale Scherkraft ergeben, sondern es kann sogar für die Bondparameter ein Bereich bestimmt werden, innerhalb dessen eine vorbestimmte Scherkraft erreicht wird. Es kann also auch ein Bereich der Grösse G und die zugehörigen Werte für die Bondkraft $F_B$, die Ultraschallgrösse P und, gegebenenfalls, den mindestens einen weiteren Bondparameter bestimmt werden, in welchem Bereich die Grösse G vorbestimmte Kriterien erfüllt.

Wenn die optimalen Bondparameter ermittelt worden sind, dann kann aus den vom Sensor gelieferten Signalen auch die für den Bondvorgang nötige Zeitdauer, während der Ultraschall zugeführt werden muss, abgeleitet werden. Die Zufuhr von Ultraschall kann nämlich beendet werden, sobald der Zeitpunkt $t_b$, der wie oben erläutert bestimmt werden kann, erreicht wird.

Eine andere Darstellung für die Reibeleistung $Q(t)$ im Intervall $[t_2, t_3]$ ist

$$Q(t) = 4*f*F_x(t)*[A_0 - k_S*F_x(t)] \qquad (5)$$

wobei f die Frequenz des Ultraschalls, $A_0$ die Amplitude der frei freischwingenden Unterseite der Bondkugel (Ball), $F_x$ die auf den jeweiligen Anschlusspunkt ausgeübte Scherkraft und $k_S$ eine die Steifigkeit des Systems "Kapillare - Goldkugel - Kontaktbereich" charakterisierende Konstante bezeichnen, wobei die Steifigkeit invers proportional zu $k_S$ ist.

Unter der Annahme, dass das Sensorsignal $S(t)$ proportional zur Scherkraft $F_x(t)$ ist, also

$$S(t) = F_x(t) / s_0 \qquad (6)$$

ist, wobei die Grösse $s_0$ eine Konstante ist, kann die in Gleichung (1) angeführte Reibeleistung $Q(t)$ dargestellt werden als

$$Q(t) = q_1 * S(t) + q_2 * S^2(t) \qquad (7)$$

wobei $q_1$ und $q_2$ Konstanten sind, die gegeben sind durch:

$$q_1 = 4 * f * A_0 * s_0 \qquad (8)$$

$$q_2 = -4 * f * k_s * s_0^2 \qquad (9)$$

Die Konstante $s_0$ kann durch eine Eichmessung mit einem Schertestgerät ermittelt werden, indem die vom Schertestgerät beim Abscheren einer auf dem Kontaktbereich des Sensors gebondeten Bondkugel gemessene Scherkraft mit dem vom Sensor simultan gelieferten Signal verglichen wird. Die Amplitude $A_0$ der freischwingenden Unterseite der Bondkugel kann, beispielsweise mit einem Vibrometer, näherungsweise bestimmt werden, indem man die Amplitude der freischwingenden Spitze der Kapillare misst.

Die Konstante $k_S$ kann aus der Form des gemessenen Signals $S(t)$ bestimmt werden. Die Scherkraft $F_x(t)$ und die Bondkraft $F_n$ sind durch die Gleichung

$$F_x(t) = \mu(t) * F_n \qquad (10),$$

verknüpft, wobei $\mu(t)$ als Reibungskoeffizient bezeichnet wird. Mit zunehmender Stärke der Verbindung zwischen Bondkugel und Kontaktbereich nimmt der Reibungskoeffizient $\mu(t)$ zu. Unter der plausiblen Annahme, dass die Geschwindigkeit des Verbindungswachstums, d.h. die Änderungsrate des Reibungskoeffizienten $\mu(t)$, nach dem Durchlaufen des lokalen Minimums $M_2$ proportional zur Reibeleistung ist:

$$d\mu(t)/dt = k_B * Q(t) \qquad (11),$$

wobei die Grösse $k_B$ die Proportionalitätskonstante bezeichnet, erhält man aus den Gleichungen (6) bis (11) eine Differentialgleichung für das Sensorsignal $S(t)$ mit der analytischen Lösung

$$S_c(t) = \frac{c_1 * e^{c_1 t}}{\dfrac{c_1}{S(t_2)} - c_2 * e^{c_1 t}} \qquad (12),$$

wobei die Konstanten $c_1$ und $c_2$ gegeben sind durch:

$$c_1 = 4 * f * A_0 * F_n * k_B \qquad (13)$$

$$c_2 = -4 * f * k_S * s_0 * F_n * k_B \qquad (14).$$

Durch einen Fit des gemessenen Sensorsignals $S(t)$ an die durch Gleichung (12) vorgegebene Funktion $S_c(t)$ im Intervall $[t_2, t_3]$, oder in einem kleineren Intervall $[t_2, t_3 - r * (t_3 - t_2)]$, wobei r ein Faktor zwischen 0 und 1 ist, erhält man die Konstanten $k_B$ und $k_S$. Damit kann die Reibearbeit gemäss den Gleichungen (1) und (7) - (9) als absolute Grösse aus dem Sensorsignal $S(t)$ bestimmt werden.

Auch wenn bei dieser zweiten Alternative nur die Umhüllende S(t) des Sensorsignals $U_{out}$(t) benötigt wird, um die Reibearbeit $W_{n,m}$ zu bestimmen, so ist es dennoch vorteilhaft, die Umhüllende $A_1$(t) der ersten Harmonischen und/oder die Umhüllende $A_3$(t) der dritten Harmonischen zu benützen, um den Zeitpunkt $t_b$ zu bestimmen, der das Ende des Integrationsintervalls gemäss Gleichung (1) bezeichnet.

Beispiel 2

Bei diesem Beispiel ist die Grösse $G_{n,m}$ die während des Bondvorganges auf den Halbleiterchip übertragene Wärmeenergie, die sich darstellen lässt als

$$V_{n,m} = \frac{1}{\rho} \int_{t_a}^{t_b} \Delta T(t) dt \qquad (15)$$

wobei die Konstante p einen thermischen Widerstand und die Grösse $\Delta T$ die Temperaturänderung bezeichnen. Die Temperaturänderung $\Delta T$ wird beispielsweise mittels eines neben dem Kontaktbereich angeordneten Temperatursensors gemessen. Ein geeigneter Temperatursensor ist aus der europäischen Patentanmeldung EP 953 398 A1 oder aus dem oben zitierten Artikel "Active test chips for in situ wire bonding process characterisation" bekannt. Um die Messung von nicht vom Verschweissen des Golddrahtes herrührende Temperaturänderungen zu vermeiden, wird der Ultraschall erst eingeschaltet, wenn das vom Temperatursensor gelieferte Signal annähernd konstant ist. Dann wird der Ultraschall eingeschaltet und nach einer vorbestimmten Zeitdauer ausgeschaltet. Das vom Temperatursensor gelieferte Signal $\Delta T$(t) zeigt qualitativ etwa den in der Fig. 7 dargestellten Verlauf. Nach dem Einschalten des Ultraschalls zum Zeitpunkt t=0 steigt das Signal $\Delta T$(t) an, erreicht zuerst ein Maximum und dann einen Wendepunkt 15, wo die Kurvenform von einer konvexen in eine konkave Form übergeht. Der Wendepunkt 15 kann auch mit dem Maximum zusammenfallen. Es hat sich gezeigt, dass sich die auf dem Kontaktbereich aufgeschweisste Goldkugel nach dem Erreichen des Wendepunkts 15 schnell verformt. Bei der Ermittlung der übertragenen Wärmeenergie $V_{n,m}$ gemäss Gleichung (15) ist der Zeitpunkt $t_a$ der Zeitpunkt t=0, an dem der Ultraschall eingeschaltet wird, und der Zeitpunkt $t_b$ ist der Zeitpunkt, an dem der Wendepunkt 15 erreicht wird oder spätestens der Zeitpunkt, an dem der Ultraschall ausgeschaltet wird.

Dieses Verfahren eignet sich vorwiegend dann, wenn der Bondvorgang im Bereich der Raumtemperatur durchgeführt wird. Bei höheren Temperaturen kann die Bestimmung des Wendepunkts 15 schwierig sein.

Beispiel 3

Bei diesem Beispiel wird als charakteristische Grösse $G_{n,m}$ die relative Änderung $\Delta\mu$ des Reibungskoeffizienten $\mu$(t) zwischen der Bondkugel und dem Kontaktbereich verwendet. Als Sensor dient der gleiche Sensor wie beim ersten Beispiel. Der Reibungskoeffizient $\mu$(t) ist mit der Umhüllenden S(t) des Ausgangssignals $U_{Out}$(t) des Sensors verknüpft über die Beziehung:

$$S(t) = \mu(t) * F_n / s_0 \qquad (16)$$

wobei $s_0$ eine Konstante und $F_n$ die aktuelle Bondkraft bezeichnen. Die Grösse $G_{n,m}$ kann aus der Umhüllenden S(t) berechnet werden zu:

$$G_{n,m} = \Delta\mu_{n,m} = \frac{2M_3}{M_1 + M_2} \qquad (17)$$

wobei die Grösse $M_1$ das erste lokale Maximum, die Grösse $M_2$ das erste lokale Minimum und die Grösse $M_3$ das globale Maximum der Umhüllenden S(t) bezeichnen (siehe Fig. 6). Falls das lokale Maximum $M_1$ und das lokale Minimum $M_2$ nicht auftreten, werden an ihrer Stelle die Werte verwendet, wo die Kurve S(t) jeweils ihre Steilheit abrupt ändert, wie dies bereits beim ersten Beispiel erläutert wurde.

Es kann alternativ auch eine der folgenden Beziehungen für die Charakterisierung der relativen Änderung $\Delta\mu$ des Reibungskoeffizienten $\mu$(t) verwendet werden:

$$G_{n,m} = \Delta\mu_{n,m} = \frac{M_3}{M_1} \qquad (18)$$

$$G_{n,m} = \Delta\mu_{n,m} = \frac{M_3}{M_2} \qquad (19)$$

$$G_{n,m} = \Delta\mu_{n,m} = (M_3 - M_1) * s_0 / F_n \qquad (20)$$

Für die Ermittlung der Reibearbeiten $W_{n,m}$ gemäss dem ersten Beispiel kann anstelle des Sensors gemäss Fig. 1 auch ein externer Sensor verwendet werden, insbesondere ein Vibrometer 16, das Oberflächenschwingungen auf der Basis der Laserdopplervibrometrie berührungslos misst. Ein geeignetes Vibrometer wird z.B. von der Firma Polytec vertrieben. Die Fig. 8 zeigt schematisch den Einsatz des Vibrometers. Der Messkopf 17 des Vibrometers 16 sendet einen Laserstrahl 18 aus, der bevorzugt unter senkrechtem Winkel auf eine Seitenfläche 19 des auf einem Substrat 20 montierten Halbleiterchips 21 auftrifft, dort reflektiert wird und wieder auf den Messkopf 17 des Vibrometers 16 trifft. Der Laserstrahl 18 trifft bevorzugt in der Nähe der oberen Kante der Seitenfläche 19 auf. Die Kontaktbereiche, auf die gebondet wird, sind in der Nähe der Seitenfläche 19 angeordnet, so dass die von der Kapillare auf den Halbleiterchip übertragenen Schwingungen die Seitenfläche 19 zum Schwingen bringen. Das Vibrometer 16 liefert ein qualitativ gleichwertiges Signal wie der Sensor gemäss Fig. 1 und die Auswertung kann deshalb auf die gleiche Weise erfolgen wie beim Beispiel 1.

Der Vorteil des Vibrometers liegt darin, dass sich damit die optimalen Bondparameter für jeden beliebigen Halbleiterchip ermitteln lassen, insbesondere von solchen ohne integrierten Sensor. Das Vibrometer kann deshalb auch benutzt werden, um das Bonden während der Produktion laufend zu überwachen, und der Wire Bonder kann eingerichtet werden, einen Alarm abzugeben, wenn die gemessene Grösse G einen vorbestimmten Mindestwert unterschreitet.

Es ist weiter möglich, dass am Horn ein piezoelektischer Sensor angebracht wird, insbesondere im Bereich des Befestigungsflansches, mit dem das Horn am Bondkopf des Wire Bonders befestigt wird, wobei der Sensor so ausgelegt sein muss, dass er ein mit der Tangentialkraft $F_x$ korrelierendes Signal liefert.

**Patentansprüche**

1.  Verfahren für die Bestimmung optimaler Bondparameter für eine Bondkraft $F_B$ und eine Ultraschallgrösse P und, fakultativ, mindestens einen weiteren Bondparameter eines Wire Bonders für einen Bondprozess, **gekennzeichnet durch die Schritte:**

    a) Durchführen von mehreren Bondvorgängen, wobei die Bondkraft $F_B$ und die Ultraschallgrösse P und, gegebenenfalls, der mindestens eine weitere Bondparameter in je einem vorbestimmten Bereich in diskreten Schritten variiert werden, wobei während des Bondens für jeden Bondvorgang mittels eines Sensors (1; 16) erzeugte elektrische Signale erfasst werden,

    b) für jeden Bondvorgang Ermitteln einer Grösse G aus den während des Bondvorganges vom Sensor gelieferten elektrischen Signalen,

    c) Bestimmung des maximalen Wertes der Grösse G und der zugehörigen Werte für die Bondkraft $F_B$, die Ultraschallgrösse P und, gegebenenfalls, den mindestens einen weiteren Bondparameter oder Bestimmung eines globalen Maximums der Grösse G und Bestimmung der zugehörigen Werte für die Bondkraft $F_B$, die Ultraschallgrösse P und, gegebenenfalls, den mindestens einen weiteren Bondparameter oder Bestimmung eines Bereichs der Grösse G, in welchem die Grösse G vorbestimmte Kriterien erfüllt, und Bestimmung der zugehörigen Werte für die Bondkraft $F_B$, die Ultraschallgrösse P und, gegebenenfalls, den mindestens einen weiteren Bondparameter.

2.  Verfahren nach Anspruch 1, **dadurch gekennzeichnet, dass** bei jedem Bondvorgang auf einen Kontaktbereich (9) eines Halbleiterchips (21) gebondet wird, und dass der Sensor ein im Halbleiterchip integrierter piezoresistiver Sensor ist.

3. Verfahren nach Anspruch 1 oder 2, **dadurch gekennzeichnet, dass** aus dem vom Sensor gelieferten Signal eine Reibeleistung Q(t) abgeleitet wird, und dass die Grösse $G_{n,m}$ einer während des Bondvorgangs geleisteten Reibearbeit entspricht.

4. Verfahren nach Anspruch 1, **dadurch gekennzeichnet, dass** bei jedem Bondvorgang auf einen Kontaktbereich (9) eines Halbleiterchips (21) gebondet wird, dass der Sensor ein im Halbleiterchip integrierter Temperatursensor ist und dass die Grösse G einer während des Bondvorgangs auf den Halbleiterchip übertragenen Wärmeenergie entspricht.

5. Verfahren nach Anspruch 1, **dadurch gekennzeichnet, dass** bei jedem Bondvorgang eine Bondkugel auf einen Kontaktbereich (9) eines Halbleiterchips (21) gebondet wird und dass die Grösse G einer während des Bondvorgangs erfolgten Änderung des Reibungskoeffizienten zwischen der Bondkugel und dem Kontaktbereich entspricht.

6. Verfahren nach einem der Ansprüche 1, 3 oder 5, **dadurch gekennzeichnet, dass** als Sensor ein Vibrometer (16) dient, das einen Laserstrahl (18) auf eine Seitenfläche (19) eines bzw. des Halbleiterchips (21) sendet.

Fig. 1

Fig. 2

Fig. 3

Fig. 4

Fig. 5

Fig. 6

Fig. 7

Fig. 8

**Europäisches Patentamt**

# EUROPÄISCHER RECHERCHENBERICHT

**Nummer der Anmeldung**

EP 02 00 2445

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | US 3 458 921 A (CHRISTENSEN FRANK W) 5. August 1969 (1969-08-05) | 1,2,4 | B23K20/00 |
| A | * Spalte 11, Zeile 30-34 * <br> * Spalte 11, Zeile 18-39 * <br> * Spalte 12, Zeile 65 - Spalte 13, Zeile 3; Abbildungen 22-24 * <br> --- | 3,5,6 | |
| Y,D | MAYER M ET AL: "Active test chips for in situ wire bonding process characterisation" <br> PROCEDINGS OF SEMICON SINGAPORE 2001, XP008002355 <br> Singapore <br> ISBN: 0-7803-5232-7 | 1,2,4 | |
| A | * Zusammenfassung * <br> --- | 3,5,6 | |
| A | EP 0 953 398 A (ESEC SA) 3. November 1999 (1999-11-03) <br> * Zusammenfassung; Abbildungen 1,2 * <br> --- | 1-6 | |
| A | US 4 815 001 A (UTHE P MICHAEL ET AL) 21. März 1989 (1989-03-21) <br> * Spalte 5, Zeile 62-65 * <br> * Spalte 63-11; Abbildungen 8,9 * <br> --- | 1-6 | RECHERCHIERTE SACHGEBIETE (Int.Cl.7) <br> B23K |
| A | EP 0 786 323 A (EMERSON ELECTRIC CO) 30. Juli 1997 (1997-07-30) <br> * Seite 1, Zeile 29-35; Abbildung 2 * <br> * Seite 1, Zeile 51-56 * <br> --- | 1-6 | |

-/--

Der vorliegende Recherchenbericht wurde für alle Patentansprüche erstellt

| Recherchenort | Abschlußdatum der Recherche | Prüfer |
|---|---|---|
| DEN HAAG | 22. April 2002 | Jaeger, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

............................................................
& : Mitglied der gleichen Patentfamilie, übereinstimmendes Dokument

EPO FORM 1503 03.82 (P04C03)

Europäisches
Patentamt

**EUROPÄISCHER RECHERCHENBERICHT**

Nummer der Anmeldung

EP 02 00 2445

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A,D | SCHWIZER J ET AL: "Thermosonic ball bonding: friction model based on integrated microsensor measurements" ELECTRONICS MANUFACTURING TECHNOLOGY SYMPOSIUM, 1999. TWENTY-FOURTH IEEE/CPMT AUSTIN, TX, USA 18-19 OCT. 1999, PISCATAWAY, NJ,USA,IEEE, US, 18. Oktober 1999 (1999-10-18), Seiten 108-114, XP010359973 ISBN: 0-7803-5502-4 * das ganze Dokument * ----- | 3,5,6 | |
| | | | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| DEN HAAG | 22. April 2002 | Jaeger, H |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

                                          
& : Mitglied der gleichen Patentfamilie,übereinstimmendes
    Dokument

EPO FORM 1503 03.82 (P04C03)

**EP 1 332 826 A1**

**ANHANG ZUM EUROPÄISCHEN RECHERCHENBERICHT
ÜBER DIE EUROPÄISCHE PATENTANMELDUNG NR.**

EP 02 00 2445

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-04-2002

| Im Recherchenbericht angeführtes Patentdokument | | Datum der Veröffentlichung | Mitglied(er) der Patentfamilie | | | Datum der Veröffentlichung |
|---|---|---|---|---|---|---|
| US 3458921 | A | 05-08-1969 | BE | 684350 | A | 03-01-1967 |
| | | | DE | 1577011 | A1 | 10-07-1969 |
| | | | FR | 1487050 | A | 30-06-1967 |
| | | | GB | 1153002 | A | 21-05-1969 |
| | | | NL | 6610145 | A | 20-01-1967 |
| | | | SE | 333413 | B | 15-03-1971 |
| EP 0953398 | A | 03-11-1999 | EP | 0953398 | A1 | 03-11-1999 |
| | | | JP | 2000068318 | A | 03-03-2000 |
| US 4815001 | A | 21-03-1989 | EP | 0247291 | A2 | 02-12-1987 |
| EP 0786323 | A | 30-07-1997 | US | 5772814 | A | 30-06-1998 |
| | | | CA | 2186633 | A1 | 27-07-1997 |
| | | | EP | 0786323 | A1 | 30-07-1997 |
| | | | JP | 9207219 | A | 12-08-1997 |

EPO FORM P0461

Für nähere Einzelheiten zu diesem Anhang : siehe Amtsblatt des Europäischen Patentamts, Nr.12/82